# EUROPEAN PATENT SPECIFICATION

(11) **EP 0 713 275 B1**
(45) Date of publication and mention of the grant of the patent: **05.04.2000**
(21) Application number: 95308242.7
(22) Date of filing: 17.11.1995
(51) Int. Cl.: H01S 5/10, H01S 5/32, H01L 33/00

(54) **Method for fabricating a semiconductor laser diode**
Herstellungsverfahren eines Halbleiterdiodenlasers
Méthode de fabrication d'un laser à diode à semi-conducteur

(30) Priority: 19.11.1994 KR 9430494
(43) Date of publication of application: 22.05.1996
(73) Proprietor: LG ELECTRONICS INC., Seoul (KR)
(72) Inventor: Yoo, Tae Kyung, Kangnam-Ku, Seoul (KR); Cho, Meoung Whan, Anyang-Si, Kyungki-Do (KR); Seo, Ju Ok, Anyang-Si, Kyungki-Do (KR); Leem, Shi Jong, Socho-ku, Seoul (KR); Noh, Min Soo, Kangnam-ku, Seoul (KR)
(74) Representative: Cross, Rupert Edward Blount

(56) References cited:
- PATENT ABSTRACTS OF JAPAN vol. 005 no. 040 (E-049) ,17 March 1981 & JP-A-55 162288 (NIPPON TELEGR & TELEPH CORP) 17 December 1980,
- PATENT ABSTRACTS OF JAPAN vol. 005 no. 186 (E-084) ,25 November 1981 & JP-A-56 112786 (NEC CORP) 5 September 1981,
- PATENT ABSTRACTS OF JAPAN vol. 014 no. 308 (E-0947) ,3 July 1990 & JP-A-02 098989 (MITSUBISHI ELECTRIC CORP) 11 April 1990,
- PATENT ABSTRACTS OF JAPAN vol. 012 no. 420 (E-679) ,8 November 1988 & JP-A-63 158888 (MATSUSHITA ELECTRIC IND CO LTD) 1 July 1988,

## Description

### 1. Field of the Invention

The present invention relates to a semiconductor laser diode, and more particularly to a method for performing etching and regrowth of a semiconductor layer of a semiconductor laser via a process once by using a liquid phase epitaxy (hereinafter referred to as LPE).

### 2. Description of the Prior Art

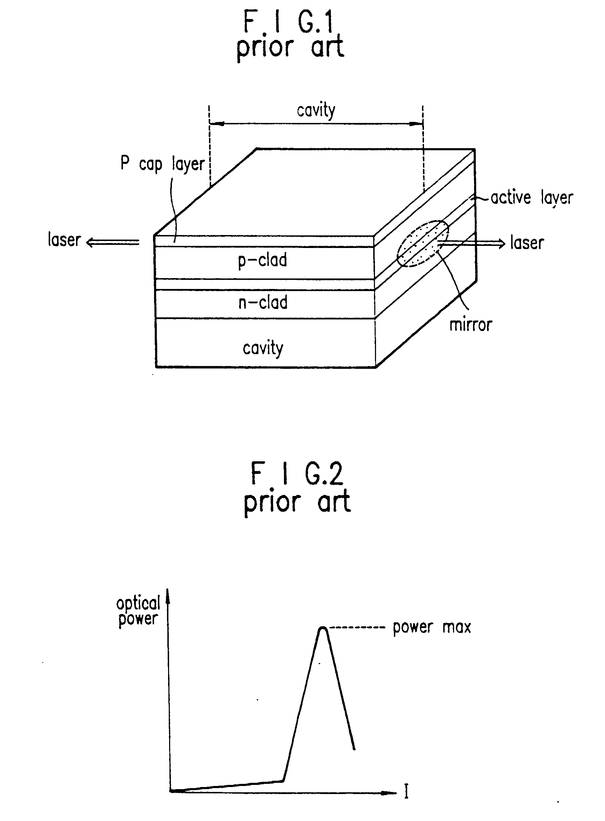

FIG. 1 illustrates a general semiconductor laser diode having a double hetero (hereinafter referred to as "DH") structure.

That is, the general semiconductor laser diode is formed by sequentially stacking an n-type clad layer, an active layer, a p-type clad layer and a p-type cap layer on a substrate.

The semiconductor laser diode has an oscillating mirror as a solid laser diode or a gas laser diode.

At this time, the oscillating mirror is formed by an orientational cleavage which is a characteristic of the semiconductor, and a distance between the mirrors is designated as a cavity.

When a (-) voltage is applied to the n-type clad layer and a (+) voltage is to the p-type clad layer of the semiconductor laser diode, an electron is coupled with a hole in the active layer to generate beam which is oscillated via the oscillating mirror to be output.

Accordingly, the oscillating beam is emitted through the mirror plane, so that a laser characteristic is greatly affected by the condition of the mirror plane.

That is, a favorable laser beam characteristic can be obtained by the flat and clear mirror plane with no damage and a parallel arrangement of the mirror and mirror which become both planes of the cavity.

However, the semiconductor laser having a specific circumstance that a semiconductor material directly contact air at the mirror plane involves an important factor to be considered.

In other words, since the mirror of the semiconductor layer is formed by using the orientational characteristic of the semiconductor to be cleaved, the mirror becomes a boundary of the semiconductor having a different property from that of an inside of the semiconductor.

A dangling bond remaining without being united exists in the boundary of the semiconductor, which is bonded with the oxygen in the air to be oxidized. Also, there is a semiconductor defect.

Once current is injected to the semiconductor laser, a photon is produced by a light-emitting reunion of the electron and hole within an active region. The photon is amplified while reciprocating between the mirrors forming the cavity to emit the laser beam to the air. At this time, a wavelength of the emitted light is the same as an energy gap of the active region material.

The mirror plane acts in two ways until the laser beam is emitted into the air.

First is for serving as a reflection plane for amplifying the photon, and the second is for serving as a transmission plane for transmitting the laser beam.

Here, by a cycling of inducing a light concentration phenomenon upon the mirror plane, uniting with the dangling bond existing on the mirror plane while the photon is absorbed to the oxidizing layer and re-uniting on a non-emitting basis, the mirror is instantaneously destructed. If the mirror is destructed, the semiconductor laser cannot be operated. This phenomenon is called as a Catastrophic Optical Damage (hereinafter referred to as COD) which frequently occurs during a high output operation.

FIG. 2 represents a current characteristic with respect to an optical output when the COD phenomenon appears.

Here, the COD level is defined by a value obtained by dividing a current value under the maximum optical output by an area of a light-emitting plane of the semiconductor laser. For example, if the maximum value of the current is 100mW and the area of the light-emitting plane is 5µm², the COD level becomes 2MW/cm².

In the high output semiconductor laser, the COD level becomes the important value. As this value is high, the semiconductor laser enables the higher output operation.

In the factors impeding the heightening the COD level, two factors may be examined, briefly.

First is the mirror plane which is the semiconductor boundary, in which a defect caused during the process can be eliminated by improving the process to reduce the processing number, but the dangling bond and the resulting oxidization is an inherent problem.

Second is of an optical power concentrating on the mirror plane, which can be solved by enlarging the light-emitting area and blocking the light from being absorbed into the mirror plane. That is, the mirror is formed of a material having a lower refractive index and a greater energy gap than those of the active layer material.

The material having the lower refractive index allows the light to spread to thus widen the light-emitting area on the mirror plane and allow an optical density to be lowered, thereby heightening the COD level. In addition, if the energy gap is great, the oscillating light is not absorbed to remove the cycle of light absorbing and non-emitting reuniting generated at the mirror, so that the phenomenon of destructing the mirror can be eliminated. A mirror formed in this manner is referred to as a transparent mirror (hereinafter referred to as "TM").

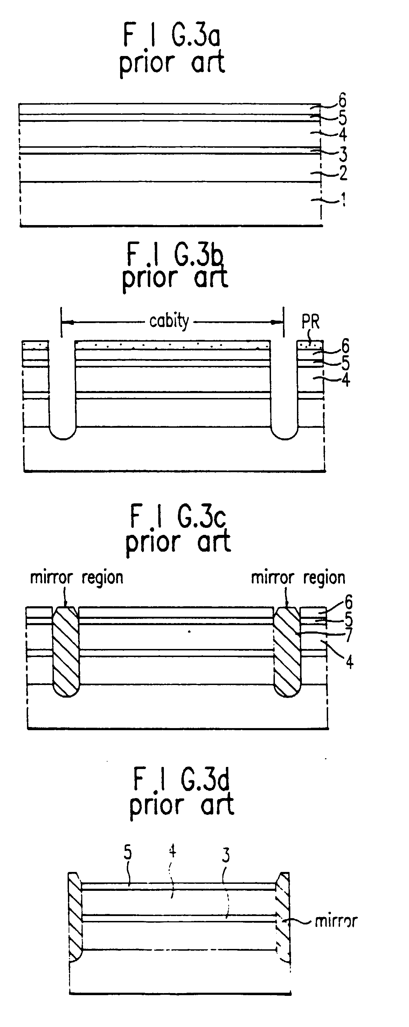

FIGS. 3A to 3D are sectional views showing a process of fabricating the conventional semiconductor laser diode having the TM layer.

To begin with, as shown in FIG. 3a, an n-clad layer 2, an active layer 3 and a p-clad layer 4 are sequentially grown on a substrate 1 via a vapor phase epitaxy such as a metal organic chemical vapor deposition (MOCVD) and mocular beam epitaxy (MBE) or LPE to form the DH structure.

A p-cap layer 5 is formed on the resultant structure, and a dielectric layer 6 such as silicon dioxide (SiO₂) or silicon nitride (Si₃N₄) is deposited on p-cap layer 5 via a plasma enhanced chemical vapor deposition (PECVD). Here, dielectric layer 6 serves as a mask for blocking the deposition from the upper side of dielectric layer 6 in case of a regrowth.

As shown in FIG. 3b, a photoresist layer PR is deposited on dielectric layer 6, and a cavity region and a mirror region are defined by means of a photolithography process to etch dielectric layer 6 and the DH structure of the mirror region down to the surface of substrate 1.

Successively, as shown in FIG. 3c, a TM layer 7 having the lower refractive index and greater energy gap than those of active layer 13 is regrown on the etched portion via the vapor phase epitaxy or LPE.

Thereafter, as shown in FIG. 3d, dielectric layer 6 is removed, and a semiconductor laser diode chip is fabricated via scribing and breaking processes.

The semiconductor laser diode fabricated as above has the cleaved mirror plane filled with the material having the lower refractive index and greater energy gap than those of the active layer to heighten the COD level, thereby being able to perform the high output operation.

The semiconductor laser diode illustrated in FIG. 3 heightens the COD level to enable the high output operation, but involves a lot of problems in the aspect of reliability with respect to a long time.

That is, when etching the DH structure of FIG. 3b , an etchant chemically removes the semiconductor material, in which the portion exposed to the etchant is damaged to be apt to create a defect. Also, since the etching is carried in an atmospheric ambient, the oxygen in the air is combined with the etched plane to result in the oxidization. The defect and oxidization may cause leakage current when injecting the current and become a heat source by absorbing the laser beam when passing therethrough to cause an abrupt deterioration of the semiconductor laser. Moreover, since the oxidization results in a defect of impeding the regrown semiconductor to have a good layer quality when regrowing the TM layer, thereby probably blocking the regrowth of the TM layer.

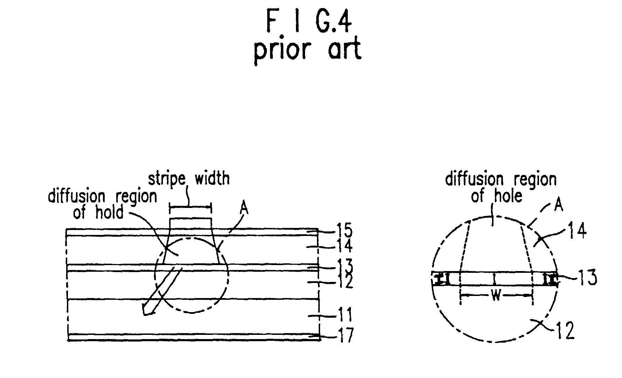

Meanwhile, FIG. 4 is a sectional view showing a structure of the semiconductor laser diode having a stripe type DH structure formed with a p-type and n-type metal electrodes.

That is, an active layer 13 is sandwitched between an n-type and a p-type clad layers 12 and 14 having the lower refractive index and greater energy gap on a substrate 11. Here, the clad layers confine light generated from the active layer to leave on the active layer.

A p-type cap layer 15 is formed on p-type clad layer 14, and a p-type metal electrode 16 and an n-type metal electrode 17 are formed to the upper portion of p-type cap layer 15 and the rear plane of p-type metal electrode 16, in which p-type metal electrode 16 is formed on a predetermined portion of p-type cap layer 15 as stripes.

The semiconductor laser diode constructed as above has the following characteristics.

When using general thin film deposition method (e.g., LPE, MOCVD and MBE), the thin film is grown in the vertical direction of the substrate, so that it is easy to grow the clad layer of the material having the lower refractive index and greater energy gap on/below the active layer in the vertical direction.

A principle of confining the light is of the full reflection produced when the light is incident from a material of high refractive index to a material of a low refractive index. That is, as the difference of the refractive index is great, the full reflection is easily produced while facilitating the light confinement. The refractive index of the active layer can be different from that of the clad layer by differing the materials.

As can be noted in an enlargement view of a portion A of FIG. 4, however, the material of the active layer has no change in the horizontal direction to inhibit the light confinement. If the light is not confined, the lower current oscillation becomes difficult and a single mode oscillation is impossible, either. A simple solution of this problem is for reducing the width of the stripe to allow a portion contacting the active layer to be an area I in the enlargement view of portion A. Area I has higher electron-hole pair density than an area II, and this density difference serves as a factor of making the refractive index of area I greater than that of area II. If the difference of the refractive index between area I and area II is higher than 10⁻⁴, the light confinement phenomenon can be obtained. But this difference of the refractive index is not a real index difference resulting from the different materials but from an effective index difference. Besides, since the electron-hole pair density cannot be infinitely heightened, the index difference is significantly smaller than the real index. In other words, the general DH structure easily realizes an up-and-down real index guiding in the vertical direction of the active layer, but involves relatively too weaker effective index guiding in the horizontal direction of the active layer. A width W of area I involves an important indication that the greater width makes the lower current oscillating difficult and impedes the single mode oscillation. In order to reduce width W, the stripe width is reduced and the doping of the p-clad layer is lowered. However, both methods can be adopted just to some extent since a resistance is increased in view of the current. The ultimate solution is for forming a clad layer capable of confining current and light in the horizontal direction of the active layer. At this time, a requisite is for utilizing a material having a lower refractive index and a greater energy gap than those of the active layer. A laser diode having such an internal structure is referred to as a buried hetero (hereinafter referred to as "BH") structured laser diode. The BH-structured laser diode has a strong structural characteristic of enabling the lower current oscillation and single mode oscillation.

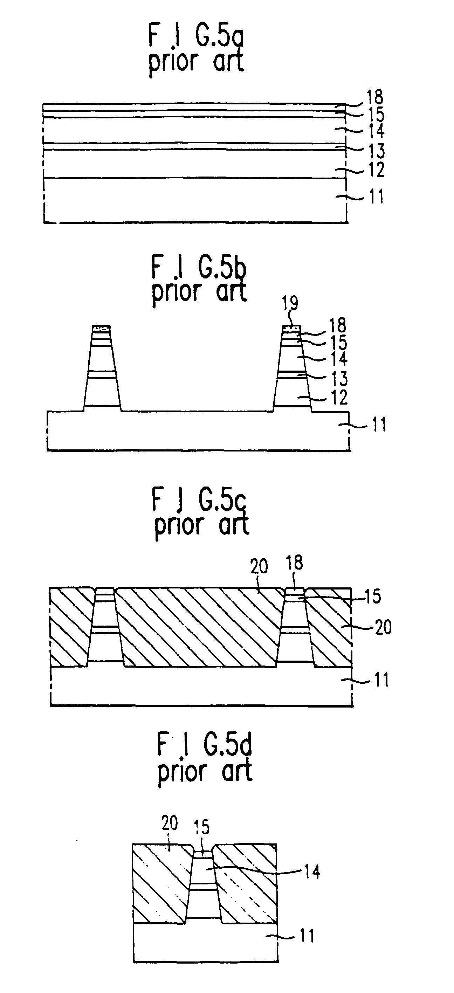

FIGS. 5a to 5d are sectional views showing a process of fabricating the conventional BH-structured semiconductor laser diode.

As shown in FIG. 5A, an n-type clad layer 12, an active layer 13, a p-type clad layer 14 and a p-type cap layer 15 are sequentially grown on a substrate 11 via the vapor phase epitaxy such as MOCVD and MBE or LPE to form the DH structure. A dielectric layer 18 is formed thereon via the PECVD.

Referring to FIG. 5b, a photoresist layer 19 is deposited on dielectric layer 18, and a photoresist layer 19 pattern is formed via a photolithography, and dielectric layer 18 is removed by means of a HF. Then, the DH structure is etched down to substrate 11 via an etching process.

As shown in FIG. 5c, a second clad layer 20 having a lower refractive index and greater energy gap than those of the active layer is grown on the etched portion via the vapor phase epitaxy or LPE. Second clad layer 20 is formed by a single layer with a lower doping density (of approximately below 10¹⁶) or a multilayered current blocking layer having a pnpn thyristor structure for enabling the low current oscillation by the current confinement as well as the light confinement.

In FIG. 5d, dielectric layer 18 is eliminated, and a chip fabricating process is performed to complete the single chip of the semiconductor laser diode.

The BH-structured laser diode fabricated as above enables the lower current oscillation of the single mode since the light confinement and current confinement are attained by the real index guiding in both vertical and horizontal directions of the active layer.

However, even though the above-described BH-structured semiconductor laser diode enables the lower current oscillation of the single mode but has problems in the aspect of reliability.

More specifically, since the etchant during etching the DH structure as shown in FIG. 5b chemically eliminates the semiconductor material, the portion exposed to the etchant is damaged to be liable to generate a defect. Moreover, the etching process is performed in the atmospheric ambient, the etched plane is combined with the oxygen in the air to be oxidized. The defect and oxidization become a reason of the leakage current, and serves as a heat source by the non-emitting reunion after absorbing the laser beam to result in an abrupt degradation of the semiconductor laser.

Furthermore, the oxidization is a reason of impeding the regrown semiconductor to have a good layer quality when regrowing the second clad layer to make it impossible to regrow the second clad layer, so that the BH laser may not be fabricated.

JP-A-55,162,288 and JP-A-56 112 786 describe methods of obtaining a high performance semiconductor laser device.

### SUMMARY OF THE INVENTION

Embodiments of the present invention are intended to address the above-described problems. Accordingly, it is an object for embodiments of the invention to provide a method for fabricating a high output semiconductor laser diode having high reliability by means of a melt-back process phenomenon which is a characteristic of a LPE.

To achieve the above object, there is provided
a method for fabricating a semiconductor laser diode comprising the steps of:
sequentially growing a clad layer of a first conductivity type, an active layer and a clad layer of a second conductivity on a substrate;
forming a dielectric layer on said clad layer of second conductivity;
selectively removing said dielectric layer to selectively expose said clad layer of second conductivity type; and
selectively removing portions of said clad layer of first conductivity, active layer and clad layer of second conductivity via a melt-back etching process by using said dielectric layer as a mask, and successively regrowing via a liquid phase epitaxy a semiconductor layer in place of said etched portions, wherein the etching via the melt-back process and the regrowth of said semiconductor layer take place without any exposure to the air, within the same liquid phase epitaxy reactor.

### BRIEF DESCRIPTION OF THE DRAWINGS

The above objects and other advantages of the present invention will become more apparent by describing in detail preferred embodiments thereof with reference to the attached drawings in which:
FIG. 1 is a sectional view showing a structure of a conventional DH structured semiconductor laser diode;
FIG. 2 is a view for illustrating a COD phenomenon in a current characteristic of the conventional semiconductor laser diode with respect to an optical power;
FIGS. 3a to 3d are sectional views showing a process of fabricating a semiconductor laser diode having a TM layer;
FIG. 4 is a sectional view showing a structure of a conventional BH-structured semiconductor laser diode;
FIGS. 5a to 5d are sectional views showing a process of fabricating the conventional BH-structured semiconductor laser diode;
FIGS. 6a to 6e are sectional views showing a process of fabricating a semiconductor laser diode according to a first embodiment of the present invention;
FIGS. 7a to 7e are sectional views showing a process of fabricating the semiconductor laser diode according to a second embodiment of the present invention;
FIG. 8 is a perspective view showing a structure of the semiconductor laser diode embodying the present invention;
FIG. 9 is a sectional view showing the structure taken along line A-A' of FIG. 8; and
FIG. 10 is a sectional view showing the structure taken along line B-B' of FIG. 8.

### DETAILED DESCRIPTION OF THE PREFERRED EMBODIMENTS

A method for fabricating a semiconductor laser diode embodying the present invention will be described with reference to accompanying drawings in detail below.

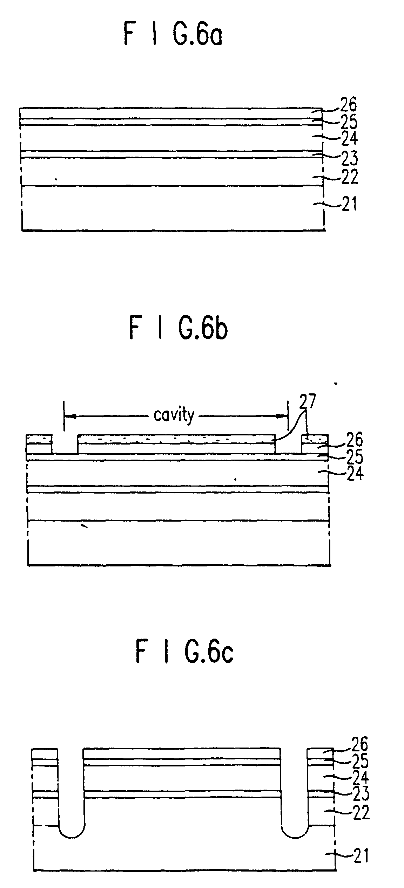

FIGS. 6a to 6e are sectional views showing a process of fabricating the semiconductor laser diode according to a first embodiment of the present invention.

As shown in FIG. 6a, an n-type clad layer 22, an active layer 23, a p-type clad layer 24 and a p-type cap layer 25 are sequentially grown on a substrate 21 via a vapor phase epitaxy such as a MOCVD and MBE or a LPE to form a DH structure.

Thereafter, a dielectric layer 26 of SiO2 or Si3N4 is deposited on p-type cap layer 25 via a PECVD.

Referring to FIG. 6b, a photoresist layer 27 is deposited on dielectric layer 26, and a mirror region is defined to be matched with a width of a cavity via a photolithography process, thereby selectively removing dielectric layer 26 of the mirror region by means of a HF.

Successively, the resultant substrate is put in a LPE reactor to perform the melt-back process as shown in FIG. 6c. The melt-back process is a characteristic of the LPE process, of which principle is as follows.

When a liquid phase of a material A is forced to contact with a solid compound semiconductor formed of materials A and B, the B material included in the solid material is melted into the A material in the liquid state on the contacting plane for balancing the overall density throughout the solid semiconductor materials AB and liquid A material. At this time, the etching of the solid semiconductor is naturally attained. By this phenomenon, the etching is performed down to the substrate as shown in FIG. 6c.

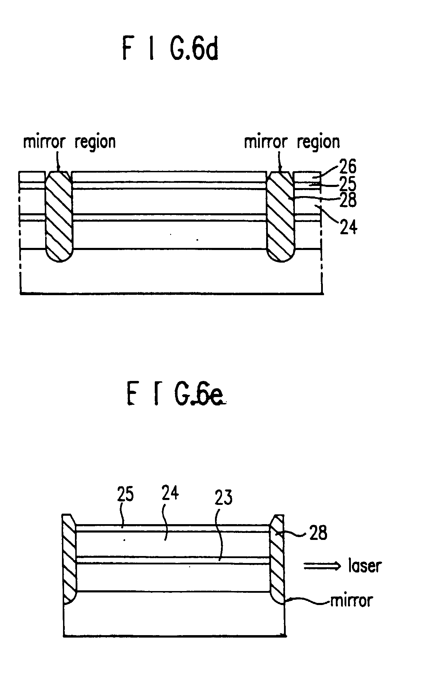

Then, as shown in FIG. 6d, a TM layer 28 of a material having a lower refractive index and a greater energy gap than those of the active layer is grown on the etched portion to easily form the high output semiconductor layer having an enhanced COD level.

Referring to FIG. 6e, dielectric layer 26 is removed, and scribing and breaking processes are performed upon the mirror region to fabricate a laser diode chip formed with the mirror.

FIGS. 7a to 7e are sectional views showing a process of fabricating a semiconductor laser diode according to a second embodiment of the present invention.

The method for fabricating the semiconductor laser diode according to the second embodiment of the present invention is performed such that, as shown in FIG. 7a, an n-type clad layer 22, an active layer 23, a p-type clad layer 24 and a p-type cap layer 25 are sequentially grown on a substrate 21 via the vapor phase epitaxy such as MOCVD and MBE or LPE to form a DH structure. A dielectric layer 26 of SiO2 or Si3N4 is formed on the resultant structure via a PECVD.

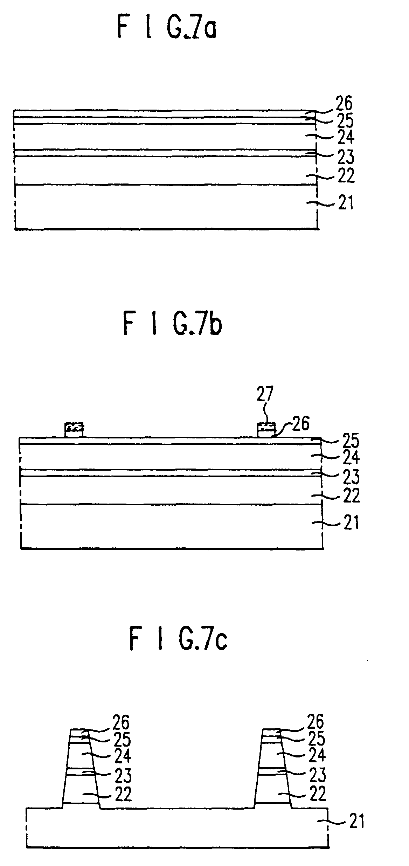

Successively, as shown in FIG. 7b, a photoresist layer 27 is formed on dielectric layer 26, and a photolithography is utilized to form a predetermined photoresist pattern. Then, dielectric layer 26 is selectively removed by means of HF.

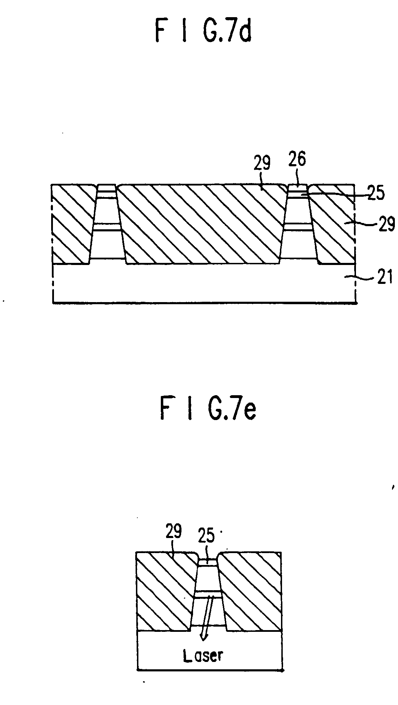

Thereafter, the resultant substrate is put in a LPE reactor to etch the DH structure down to the substrate as shown in FIG. 7c by means of the etching method described as above, and a second clad layer 29 is regrown on the etched portion within the same reactor as shown in FIG. 7d.

At this time, second clad layer 29 is formed of a material having a lower refractive index and a greater energy gap than those of the active layer. For this reason, strong light confinement appears by a real index guiding. The second clad layer may be formed of a single layer with a low doping density (of approximately lower than 10¹⁶) or multilayered CBL having a pnpn thyristor structure.

As shown in FIG. 7e, dielectric layer 26 is removed, and a chip fabricating process is carried out to fabricate a semiconductor layer diode single chip having the BH structure.

Therefore, the BH-structured laser diode fabricated as above has high reliability with respect to an operation performed for a long time. Additionally, the strong light confinement and current confinement are basically accomplished by the real index guiding in the vertical and horizontal directions in the active layer, so that the semiconductor laser diode enables the low current oscillation of a single mode.

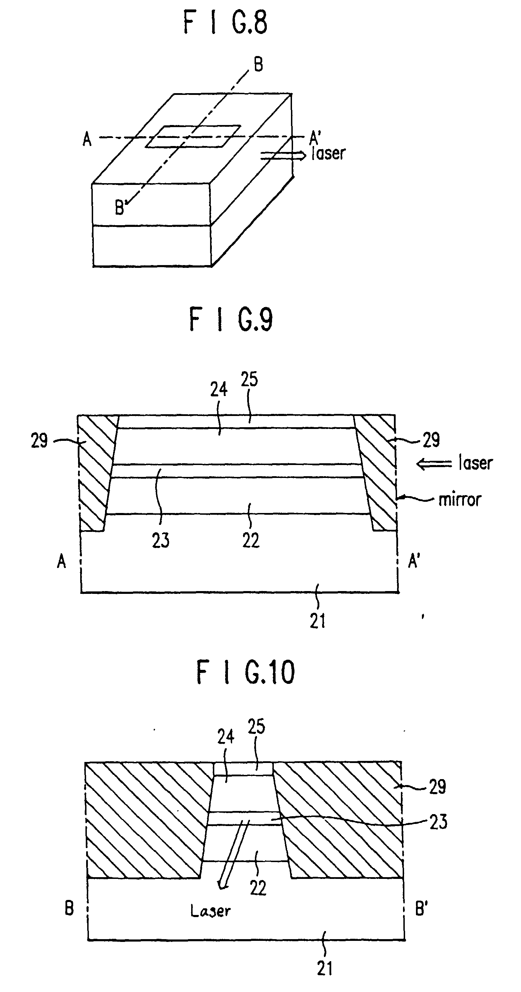

FIG. 8 is a perspective view showing the structure of the semiconductor laser diode according to a third embodiment of the present invention; FIG. 9 is a sectional view showing the structure taken along line A-A'; and FIG. 10 is a sectional view showing a structure taken along line B-B' of FIG. 8.

The semiconductor laser diode according to the third embodiment of the present invention as shown in FIG. 8 has a structure of combining the semiconductor laser diode fabricated by regrowing the TM layer according to the first embodiment and the BH-structured laser diode according to the second embodiment.

That is, FIG. 9 illustrates the plane of regrowing the TM layer, and FIG. 10 illustrates the plane of regrowing the second clad layer.

The method for fabricating the semiconductor laser diode according to the third embodiment of the present invention is the same as those of the above-described first and second embodiments, in which the fabricating methods of the first and second embodiments are simultaneously carried out to fabricate the semiconductor laser diode.

In other words, as shown in FIG. 6a or 7a, n-type clad layer 22, active layer 23, p-type clad layer 24 and p-type cap layer 25 are sequentially grown on substrate 21 via the vapor phase epitaxy MOCVD and MBE or LPE to form the DH structure, and dielectric layer 26 of SiO2 or Si3N4 is formed via the PECVD.

Successively as illustrated in FIGS. 6b and 7b, photoresist layer 27 is deposited on dielectric layer 26, and a photoresist layer pattern is formed via the photolithography and dielectric layer 26 is selectively removed by means of the HF.

At this time, it is formed that photoresist layer pattern is to have the cavity width in the vertical direction and a predetermined width in the horizontal direction.

After this, the resultant substrate is put in the LPE reactor, and the above-stated liquid phase etching method is utilized to etch the DH structure down to the substrate as illustrated in FIG. 6c or 7c, and TM layer 28 or second clad layer 29 is regrown on the etched portion within the same reactor as shown in FIG. 6d or 7d.

At this time, TM layer 28 or second clad layer 29 is formed of a material having the lower refractive index and greater energy gap than those of the active layer.

As shown in FIG. 6e or 7e, dielectric layer 26 is eliminated, and the chip fabricating process is performed to fabricate the semiconductor laser diode single chip of the BH structure.

The laser diode fabricated as above has a high COD level which is the advantage of the laser diode of regrowing the TM layer to enable the high output operation as well as the low current oscillation in the single mode which is the advantage of the BH-structured laser diode.

In the method for fabricating the semiconductor laser diode as described above, the DH structure is etched by using the liquid phase etching which is the characteristic of the LPE method to instantly execute the regrowth after etching the DH structure to prevent the occurrence of a defect due to an etchant, and the structure is not exposed to air for preventing the oxidization of the etched plane to block the leakage current and abrupt degradation when using the semiconductor laser diode for a long time, thereby easily fabricating the semiconductor laser of high reliability.

While the present invention has been particularly shown and described with reference to particular embodiment thereof, it will be understood by those skilled in the art that various changes in form and details may be effected therein without departing from the scope of the invention as defined by the appended claims.

## Claims

1. A method for fabricating a semiconductor laser diode comprising the steps of:
sequentially growing a clad layer (22) of a first conductivity type, an active layer (23) and a clad layer (24) of a second conductivity on a substrate (21);
forming a dielectric layer (26) on said clad layer (24) of second conductivity;
selectively removing said dielectric layer (26) to selectively expose said clad layer (24) of second conductivity type; and
selectively removing portions of said clad layer (22) of first conductivity, active layer (23) and clad layer (24) of second conductivity via a melt-back process by using said dielectric layer (26) as a mask, and successively regrowing via a liquid phase epitaxy a semiconductor layer (28, 29) in place of said etched portions, wherein the etching via the melt-back process and the regrowth of said semiconductor layer (28;29) take place without any exposure to the air, within the same liquid phase epitaxy reactor.

2. A method for fabricating a semiconductor laser diode as claimed in claim 1, wherein said selectively removed portion of dielectric layer (26) corresponds to a mirror plane of said laser diode.

3. A method for fabricating a semiconductor laser diode as claimed in claim 1, wherein said selectively removed portion of dielectric layer (26) is a channel portion for forming a current confining layer which confines said active layer (23) of said laser diode in the horizontal direction.

4. A method for fabricating a semiconductor laser diode as claimed in claim 1, wherein said selectively removed portion of dielectric layer (26) corresponds to a channel portion for forming said current confining layer which confines said mirror plane of said laser diode and said active layer (23) of said laser diode in the horizontal direction.

5. A method for fabricating a semiconductor laser diode as claimed in claim 1, wherein said semiconductor layer (28,29) regrown on said etched portion is formed by growing a material having a lower refractive index and a higher energy gap than those of said active layer.

6. A method for fabricating a semiconductor laser diode as claimed in claim 1, wherein said semiconductor layer regrown on said etched portion is a transparent mirror layer (28) of said laser diode.

7. A method for fabricating a semiconductor laser diode as claimed in claim 1, wherein said semiconductor layer regrown on said etched portion is a clad layer (29).

## Patentansprüche

1. Verfahren zur Herstellung einer Halbleiter-Laserdiode, umfassend die Schritte:
- aufeinanderfolgendes Aufwachsen einer Kaschierschicht (22) eines ersten Leitfähigkeitstyps, einer aktiven Schicht (23) und einer Kaschierschicht (24) einer zweiten Leitfähigkeit auf einem Substrat (21),
- Bilden einer dielektrischen Schicht (26) auf der Kaschierschicht (24) der zweiten Leitfähigkeit,
- selektives Entfernen der dielektrischen Schicht (26), um die Kaschierschicht (24) des zweiten Leitfähigkeitstyps selektiv freizulegen, und
- selektives Entfernen von Teilen der Kaschierschicht (22) der ersten Leitfähigkeit, der aktiven Schicht (23) und der Kaschierschicht (24) der zweiten Leitfähigkeit mittels eines Rückschmelzprozesses unter Verwendung der dielektrischen Schicht (26) als Maske und anschließendes Wiederaufwachsen einer Halbleiterschicht (28, 29) anstelle der weggeätzten Teile mittels einer Flüssigphasen-Epitaxie, wobei das Ätzen mittels des Rückschmelzprozesses und das Wiederaufwachsen der Halbleiterschicht (28, 29) ohne Kontakt mit der Luftumgebung in demselben Flüssigphasen-Epitaxiereaktor stattfinden.

2. Verfahren zur Herstellung einer Halbleiter-Laserdiode nach Anspruch 1, bei dem der selektiv entfernte Teil der dielektrischen Schicht (26) einer Spiegelebene der Laserdiode entspricht.

3. Verfahren zur Herstellung einer Halbleiter-Laserdiode nach Anspruch 1, bei dem der selektiv entfernte Teil der dielektrischen Schicht (26) ein Kanalbereich zur Bildung einer Strombegrenzungsschicht ist, welche die aktive Schicht (23) der Laserdiode in horizontaler Richtung begrenzt.

4. Verfahren zur Herstellung einer Halbleiter-Laserdiode nach Anspruch 1, bei dem der selektiv entfernte Teil der dielektrischen Schicht (26) einem Kanalbereich zur Bildung der Strombegrenzungsschicht entspricht, welche die Spiegelebene der Laserdiode und die aktive Schicht (23) der Laserdiode in horizontaler Richtung begrenzt.

5. Verfahren zur Herstellung einer Halbleiter-Laserdiode nach Anspruch 1, bei dem die auf dem geätzten Bereich wiederaufgewachsene Halbleiterschicht (28, 29) durch Aufwachsen eines Materials gebildet wird, welches einen niedrigeren Brechungsindex und eine größere Energielücke als die aktive Schicht aufweist.

6. Verfahren zur Herstellung einer Halbleiter-Laserdiode nach Anspruch 1, bei dem die auf dem geätzten Bereich wiederaufgewachsene Halbleiterschicht eine transparente Spiegelschicht (28) der Laserdiode ist.

7. Verfahren zur Herstellung einer Halbleiter-Laserdiode nach Anspruch 1, bei dem die auf dem geätzten Bereich wiederaufgewachsene Halbleiterschicht eine Kaschierschicht (29) ist.

## Revendications

1. Procédé de fabrication d'une diode laser à semiconducteur, comprenant les étapes suivantes :
la croissance successive d'une couche de revêtement (22) d'un premier type de conductivité, d'une couche active (23) et d'une couche de revêtement (24) d'une seconde conductivité sur un substrat (21),
la formation d'une couche diélectrique (26) sur la couche de revêtement (24) de la seconde conductivité,
l'extraction sélective de la couche diélectrique (26) pour l'exposition sélective de la couche de revêtement (24) du second type de conductivité, et
l'action sélective de parties de la couche de revêtement (22) de la première conductivité, de la couche active (23) et de la couche de revêtement (24) de seconde conductivité par un procédé de refusion à l'aide de la couche diélectrique (26) comme masque, et une nouvelle croissance successive par épitaxie en phase liquide d'une couche semi-conductrice (28, 29) à la place des parties attaquées, l'attaque par l'opération de refusion et la nouvelle croissance de la couche semi-conductrice (28, 29) étant réalisées sans exposition à l'air atmosphérique ambiant, à l'intérieur du même réacteur d'épitaxie en phase liquide.

2. Procédé de fabrication d'une diode laser à semiconducteur selon la revendication 1, dans lequel la partie sélectivement enlevée de la couche diélectrique (26) correspond au plan du miroir de la diode laser.

3. Procédé de fabrication d'une diode laser à semiconducteur selon la revendication 1, dans lequel la partie retirée sélectivement de la couche diélectrique (26) est une partie de canal destinée à former une couche de confinement de courant qui délimite la couche active (23) de la diode laser en direction horizontale.

4. Procédé de fabrication d'une diode laser à semiconducteur selon la revendication 1, dans lequel la partie retirée sélectivement de la couche diélectrique (26) correspond à une partie de canal destinée à former la couche de confinement de courant qui confine le plan du miroir de la diode laser et la couche active (23) de la diode laser en direction horizontale.

5. Procédé de fabrication d'une diode laser à semiconducteur selon la revendication 1, dans lequel la couche semi-conductrice (28, 29) formée par nouvelle croissance sur la partie attaquée est réalisée par croissance d'un matériau ayant un indice de réfraction plus petit et une bande interdite plus grande que ceux de la couche active.

6. Procédé de fabrication d'une diode laser à semiconducteur selon la revendication 1, dans lequel la couche semi-conductrice formée par nouvelle croissance sur la partie attaquée est une couche transparente de miroir (28) de la diode laser.

7. Procédé de fabrication d'une diode laser à semiconducteur selon la revendication 1, dans lequel la couche semi-conductrice formée par nouvelle croissance sur la partie attaquée est une couche de revêtement (29).
